# EUROPÄISCHE PATENTSCHRIFT

(11) **EP 0 632 684 B1**
(45) Veröffentlichungstag und Bekanntmachung des Hinweises auf die Patenterteilung: **12.07.2000**
(21) Anmeldenummer: 94107879.2
(22) Anmeldetag: 21.05.1994
(51) Int. Cl.: H05K 3/40, H01L 21/48, H01L 23/13

(54) **Verfahren zum Herstellen eines Metall-Keramik-Substrates**
Process for manufacturing metal-ceramic substrate
Procédé de fabrication d'un substrat métal-céramique

(30) Priorität: 03.06.1993 DE 4318463
(43) Veröffentlichungstag der Anmeldung: 04.01.1995
(73) Patentinhaber: Schulz-Harder, Jürgen, Dr.-Ing., D-91207 Lauf (DE)
(72) Erfinder: Schulz-Harder, Jürgen, Dr.-Ing., D-91207 Lauf (DE)
(74) Vertreter: Graf, Helmut, Dipl.-Ing.

(56) Entgegenhaltungen:
- EP-A- 0 523 598
- DE-A- 3 941 814
- US-A- 4 500 029

## Beschreibung

Metall-Keramik-Substrate und insbesondere auch Metall-Kupfer-Substrate sind in den unterschiedlichsten Ausführungen bekannt und werden insbesondere für elektrische oder elektronische Schaltkreise und dabei speziell für Leistungsschaltkreise (Leistungsmodule) verwendet.

Im einfachsten Fall bestehen derartige Substrate aus einer einzigen Keramikschicht, die an beiden Oberflächenseiten mit einer Metallisierung bzw. Metallschicht und dabei vorzugsweise mit einer Kupferschicht versehen ist, wobei die an der einen Oberflächenseite der Keramikschicht vorgesehene Metallschicht bevorzugt strukturiert ist, d.h. Leiterbahnen und/oder Kontaktflächen usw. bildet, von denen beim Betrieb des elektrischen Schaltkreises zumindest ein Teil ein Spannungspotential aufweist, welches unterschiedlich von dem Spannungspotential der an der anderen Oberflächenseite der Keramikschicht vorgesehenen anderen Metallschicht ist. Durch die Keramikschicht ist grundsätzlich eine ausreichend hohe Spannungsfestigkeit zwischen den Metallschichten an den Oberflächenseiten der Keramikschicht gewährleistet. Vielfach sind aber derartige Metall-Keramik-Substrate in bestimmten Bereichen auch so ausgebildet, daß die Metallschichten an den beiden Oberflächenseiten der Keramikschicht z.B. am Rand der Keramikschicht oder im Bereich von in dieser Keramikschicht vorgesehenen Ausnehmungen, Öffnungen, Unterbrechungen usw. nur auf einem Luftweg entlang der Kante der Keramikschicht elektrisch voneinander getrennt sind, so daß sich dort eine ausreichende Spannungsfestigkeit oder ein ausreichender Isolationsabstand zwischen den Metallschichten an den beiden Oberflächenseiten der Keramikschicht für höhere Spannungen nicht erreichen läßt. Weiterhin tritt an diesen Stellen bevorzugt eine Rißbildung ein, und zwar insbesondere dann, wenn die Substrate mehrfachen Temperaturwechseln unterzogen werden. Die Rißbildung wird durch die entstehenden mechanischen Spannungen hervorgerufen, die eine Folge unterschiedlicher Ausdehnungskoeffizienten sind.

In der Regel wird in diesen Fällen die Spannungsfestigkeit durch Verwendung von Isoliermassen verbessert. Aber auch hierdurch lassen sich keine Spannungsfestigkeiten erreichen, die für höhere Spannungen, d.h. für Spannungen beispielsweise größer als 1000 V ausreichend sind. Das Auftreten von thermomechanisch induzierten Rissen kann dadurch nicht verhindert werden.

Bekannt ist es ferner, Keramik-Metall-Substrate dadurch herzustellen, daß zur Bildung der Metallschichten auf den Oberflächenseite der Keramikschicht mittels des sogenannten Direct-Bonding-Verfahrens (DB-Verfahren) oder eutektischen Bonding-Verfahrens Metallfolien oder Metallplatinen flächig zu befestigen (US 45 00 029), wobei es bei diesen Substraten auch bekannt ist, eine Metallschicht an einer Oberflächenseite der Keramikschicht in wenigstens einem Teilbereich brückenartig derart auszubilden, daß diese Metallschicht dort einen Abstand von der Ebene der betreffenden Oberflächenseite der Keramikschicht besitzt. Durch den brückenartigen Abschnitt oder Bereich ist dann bei dieser bekannten Ausgestaltung eines Metall-Keramik-Substrates eine an der gleichen Oberflächenseite der Keramikschicht vorgesehene Leiterbahn hindurchgeführt.

Bekannt ist es weiterhin auch (DE 25 08 224), auf der Oberseite einer Keramikschicht mittels des DB-Verfahrens einen Metallstreifen zu befestigen, so daß dieser mit einem Teilbereich über den Rand der Keramikschicht vorsteht. Der Metallstreifen wird hierfür zunächst an einer Oberflächenseite oxidiert. Das Oxyd wird anschließend an dem Teilbereich, mit dem der Metallstreifen über dem Rand der Keramikschicht vorstehen soll, entfernt. Anschließend wird der Metallstreifen mit seiner verbliebenen oxidierten Oberflächenseite auf die Keramikschicht aufgelegt und dann durch Erhitzen der Keramikschicht und des Metallstreifens auf eine Prozeßtemperatur, die über der eutektischen Temperatur des Metalloxyds, aber unter der Schmelztemperatur des Metalls des Metallstreifens liegt, die Verbindung hergestellt.

Aufgabe der Erfindung ist es, ein Verfahren zum Herstellen eines Metall-Keramik-Substrates aufzuzeigen, welches in solchen Bereichen, in denen zumindest eine der an einer Keramikschicht vorgesehenen Metallschichten über einen Rand oder eine Kante der Keramikschicht vorsteht, eine verbesserte Spannungsfestigkeit bzw. einen verbesserten Isolationsabstand aufweist, und das Entstehen von thermomechanisch induzierten Rissen vermeidet.

Zur Lösung dieser Aufgabe ist ein Verfahren entsprechend den Merkmalen des Patentanspruches 1 ausgebildet und ein Keramik-Metall-Substrat entsprechend den Merkmalen des Patentanspruchs 10 ausgebildet.

Bei dem erfindungsgemäßen Verfahren wird zunächst ein Ausgangssubstrat hergestellt, welches wenigstens eine Keramikschicht sowie an den Oberflächenseiten dieser Keramikschicht jeweils eine Metallschicht aufweist, wobei zumindest die eine, an der einen Oberflächenseite der Keramikschicht vorgesehene Metallschicht über eine von der Keramikschicht vorgesehene Kante vorsteht. In einem anschließenden Verfahrensabschnitt wird dann dieser vorstehende Teilbereich der wenigstens einen Metallschicht mechanisch bleibend derart verformt, daß die Metallschicht an der Kante von der Oberflächenseite der Keramikschicht beabstandet ist und entlang der Kante in einem Randbereich mit vorgegebener Breite von der Keramikschicht abgelöst ist. Durch dieses selektive und genau gesteuerte Verformen und Ablösen der Metallschicht von der Keramikschicht ergibt sich eine wesentliche Vergrößerung des für den Isolationswiderstand bzw. für die Spannungsfestigkeit maßgeblichen Abstandes zwischen der einen Metallschicht auf der einen Oberflächenseite der Keramikschicht und der anderen Metallschicht auf der anderen Oberflächenseite der Keramikschicht und damit eine wesentliche Verbesserung der Spannungsfestigkeit, und zwar bei Keramikschichten, wie sie üblicherweise für die Herstellung von Metall-Keramik-Substraten für elektrische Schaltkreises verwendet werden.

Um möglicherweise anhaftende Metallreste auf der Keramik bzw. Keramikschicht zu entfernen wird das Substrat gemäß einer bevorzugten Ausführungsform der Erfindung nach dem Verformen der wenigstens einer Metallschicht bzw. des Teilbereiches dieser Metallschicht in einem geeigneten Ätzmittel behandelt. Für Kupfer eignet sich als Ätzmittel beispielsweise eine Lösung aus 10 % Natruimpersulfat in einer 10 %igen Schwefelsäure.

Weiterbildungen der Erfindung sind Gegenstand der Unteransprüche.

Die Erfindung wird im Folgenden anhand der Figuren an Ausführungsbeispielen näher erläutert. Es zeigen:
- Fig. 1: in vereinfachter Teildarstellung und im Schnitt ein Kupfer-Keramik-Ausgangssubstrat;
- Fig. 2: in gleicher Darstellung wie Fig. 1 das Kupfer-Keramik-Substrat nach seiner Fertigstellung;
- Fig. 3: das Kupfer-Keramik-Ausgangssubstrat der Fig. 1 zusammen mit dem Werkzeug zum Umformen dieses Substrates in das Substrat der Fig. 2;
- Fig. 4 und 5: in vereinfachter Teildarstellung und im Schnitt ein weiteres Kupfer-Keramik-Ausgangssubstrat unmittelbar vor seiner endgültigen Fertigstellung bzw. nach seiner endgültigen Fertigstellung, und zwar zusammen mit einem Umformwerkzeug;
- Fig. 6 und 7: in ähnlicher Darstellung wie Figuren 4 und 5 eine weitere, mögliche Ausführung.

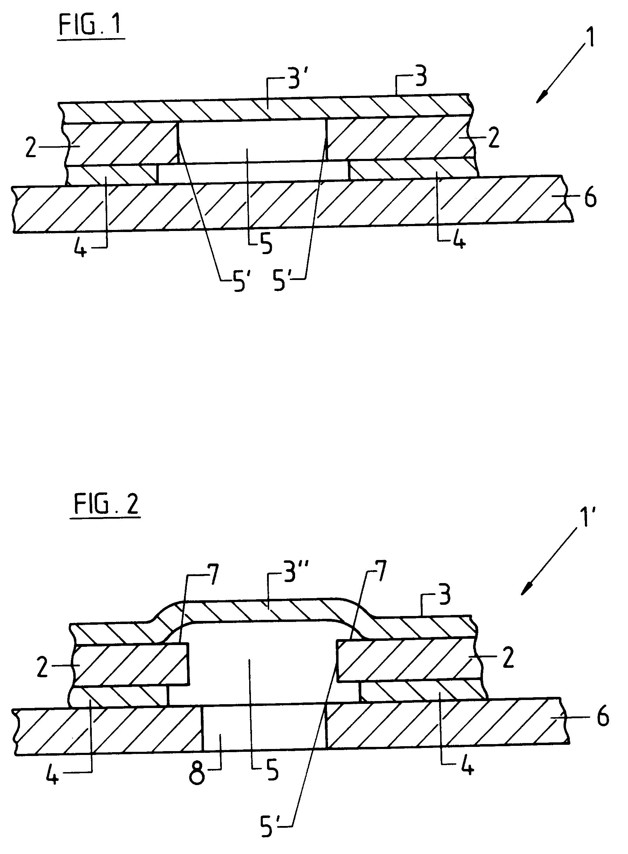

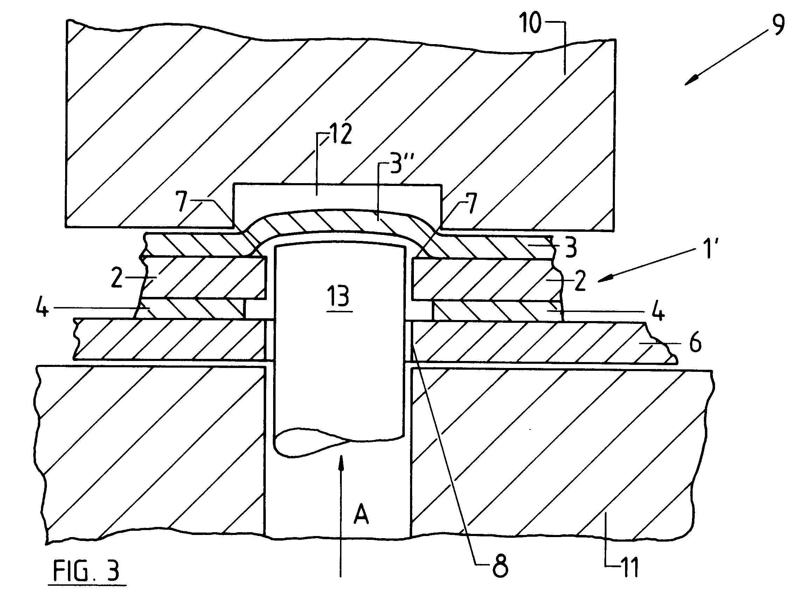

Das in der Fig. 1 dargestellte Kupfer-Keramik-Ausgangssubstrat 1 besteht im wesentlichen aus einer Keramikschicht 2, die an beiden Oberflächenseiten jeweils mit einer Metallisierung in Form einer Kupferschicht 3 bzw. 4 versehen ist. Bei 5 sind die Keramikschicht 2 sowie auch die in den Figuren 1 - 3 untere Kupferschicht 4 unterbrochen. Diese Unterbrechung 5 ist beispielsweise dadurch erzeugt, daß nach dem Aufbringen der Kupferschichten 3 und 4 auf die Keramikschicht 2 sowohl das Material der Kupferschicht 4 als auch das Material der Keramikschicht 2 im Bereich der Unterbrechung oder Öffnung 5 entfernt werden.

Das Aufbringen der Kupferschichten 3 und 4 auf die Keramikschicht 2 erfolgt mit der sogenannten Direct-Bonding-Verfahren (DB-Verfahren), welches dem Fachmann aus der Literatur bekannt ist und welches speziell bei der Herstellung von Kupferschichten auch mit Direct-Copper-Bonding-Verfahren (DCB-Verfahren) bezeichnet wird. Die vorzugsweise strukturierte, Leiterbahnen sowie Kontaktflächen bildende Kupferschicht 3 überbrückt mit einem Telbereich 3' die Öffnung 5. Die der Kupferschicht 3 abgewandte Seite der unteren Kupferschicht 4 ist mit einer Kupferplatte 6 (Tragplatte) verbunden, die eine im Vergleich zu den Kupferschichten 3 und 4 wesentlich größere Dicke aufweist und über die das Substrat 1 bzw. der von diesem Substrat und nicht dargestellten elektrischen Bauelementen gebildete Leistungsschaltkreis an einem nicht dargestellten Kühlkörper zur Ableitung der Verlustwärme befestigt ist.

Wie die Figuren zeigen, besitzt die Öffnung 5 im Bereich der Kupferschicht 4 eine größere Breite als im Bereich der Keramikschicht 2, so daß von der Kupferschicht 3 her gesehen sich der Rand der Kupferschicht 4 im Bereich der Ausnehmung 5 verdeckt hinter dem die Öffnung 5 begrenzenden Rand der Keramikschicht 2 liegt und somit der für die elektrische Isolation zwischen den Kupferschichten 3 und 4 maßgebliche Abstand vergrößert ist. Dann, wenn das Substrat 1 in Schaltkreisen verwendet wird, in denen höhere Spannungen, beispielsweise Spannungen von 1000 Volt oder größer auftreten, läßt sich aber insbesondere auch unter Berücksichtigung der Dicke der für die Herstellung von Kupfer-Keramik-Substraten zur Verfügung stehenden Keramikschichten oder -platten der für die Spannungsfestigkeit erforderliche Abstand zwischen den Kupferschichten 3 und 4 auf die vorbeschriebene Weise im Bereich einer Öffnung 5 auch dann nicht erreichen, wenn diese Öffnung mit einer Isoliermasse ausgefüllt ist, die eine höhere Spannungsfestigkeit als Luft gewährleistet.

Um an der Öffnung 5 die Spannungsfestigkeit zwischen der diese Öffnung überbrückenden Kupferschicht 3 und der Kupferschicht 4, aber auch der Kupferplatte 6 zu erhöhen und thermomechanisch induzierte Risse zu vermeiden, ist bei dem Substrat 1' der Fig. 2 die Kupferschicht 3 im Bereich der Brücke 3' nach oben gewölbt und bildet eine Brücke 3'', und zwar derart, daß hierdurch nicht nur der Abstand zwischen der Brücke 3'' und den Kupferschicht 4 bzw. 6 vergrößer ist, sondern das Kupfer der Kupferschicht 3 an den beiden Seiten der Brücke 3'' in einem Randbereich 7 von der der Kupferschicht 4 abgawandten Seite der Keramikschicht 2 abgelöst ist. Hierdurch wird also insbesondere auch der für die elektrische Spannungsfestigkeit maßgebliche Weg oder Abstand zwischen den Kupferschichten 3 und 4 entlang der Keramikschicht 2 bzw. des Randes 5' der Öffnung 5 wesentlich vergrößert wird, und zwar um die Breite der abgelösten Randbereiche 7. Durch die Verlagerung des Übergangsbereiches Kupfer-Keramik vom Keramikrand 5' weg in den flächigen Bereich werden thermomechanisch induzierte Risse vermieden.

Zur Umwandlung des Substrates 1 in das Substrat 1', welches im Vergleich zum Substrat 1 eine wesentlich höhere Spannungsfestigkeit und eine reduzierte Anfälligkeit gegen Rißbildung bei Themperaturwechseln aufweist, wird zunächst in die Kupferplatte 6, die beispielsweise durch Löten mit der Kupferplatte 4 verbunden ist, im Bereich der Öffnung 5 eine durchgehende Bohrung 8 eingebracht. Anschließend wird das Substrat 1 in ein Werkzeug 9 eingelegt, welches zwei plattenförmige Werkzeugteile 10 und 11 aufweist. Zwischen diesen wird das Substrat 1 flächig eingespannt, so daß es mit seiner oberen Kupferschicht 3 flächig gegen eine Fläche des matritzenartigen Werkzeugteils 10 und mit der Kupferplatte 6 flächig gegen eine Fläche des Werkzeugteils 11 anliegt. Das Werkzeugteil 10 besitzt an der genannten Anlagefläche dort, wo die gewölbte Brücke 3'' erzeugt werden soll, eine konkave Ausnehmung 12. Im Werkzeugteil 11 ist ein Stempel 13 senkrecht zur Anlagefläche dieses Werkzeugteils verschiebbar vorgesehen, und zwar derart, daß dieser Stempel aus einer Ausgangsposition durch die Bohrung 8 in die Öffnung 12 vorbewegt werden kann und dadurch bei im Werkzeug eingespannten Substrat 1' durch den Stempel 13 das Material des Teilbereiches 3' in die Ausnehmung 12 hineingedrückt und dadurch die gewölbte Brücke 3'' geformt wird. Die Ausnehmung 12 besitzt eine Breite, die größer ist als die entsprechende Breite der Öffnung 5 in der Keramikschicht 2, so daß beim Verformen des Teilbereichs 3' in die Brücke 3'' zugleich auch das Kupfer der Kupferschicht 3 zugleich auch von der Oberseite der Keramikschicht 2 abgelöst wird, und zwar jeweils an den Randbereichen 7. Die Breite dieser Bereiche bzw. der Ablösung läßt sich sehr exakt durch die Breite der Ausnehmung 12 bestimmen.

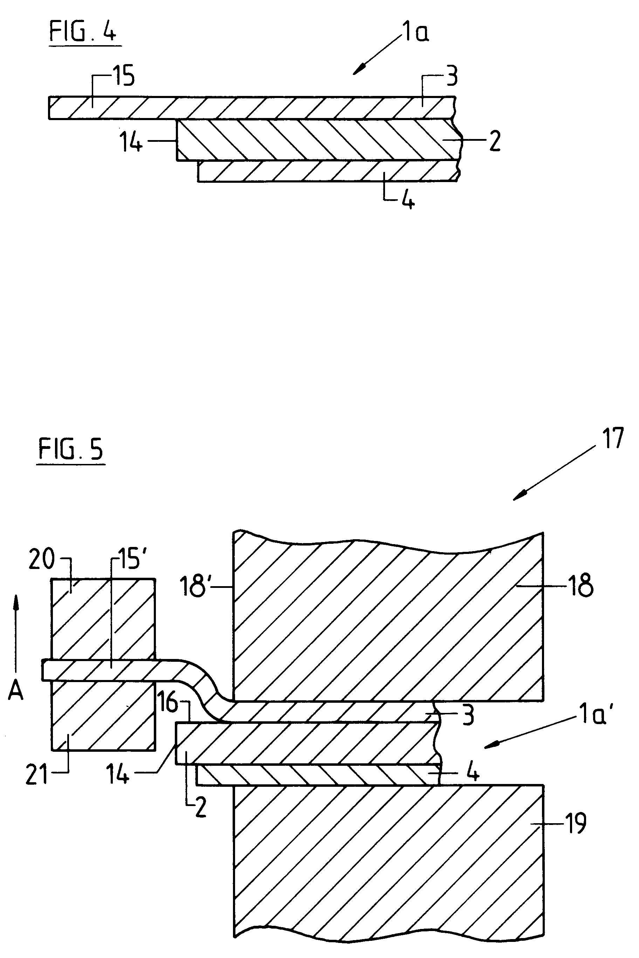

Die Figuren 4 und 5 zeigen ein Substrat 1a bzw. 1a', wobei das Substrat 1a' durch mechanische Umformung aus dem Substrat 1a hergestellt ist und die höhere Spannungsfestigkeit und reduzierte Neigung zur Rißbildung aufweist.

Im einzelnen besteht das Substrat 1a, welches ebenso wie das Substrat 1a' im Bereich eines Randes dargestellt ist, aus der Keramikschicht 2 und aus der oberen sowie der unteren Kupferschicht 3 bzw. 4. Die obere Kupferschicht, die wiederum zur Bildung von Leiterbahnen, Kontaktflächen usw. strukturiert ist, bildet am Rand 14 des Substrates eine überstehende Lasche oder einen Überstand 15, der beispielsweise ein äußerer Anschluß des elektrischen Schaltkreises ist. Zur Erhöhung der Spannungsfestigkeit zwischen den Kupferschichten 3 und 4 bzw. zwischen dem Überstand 14 und der Kupferschicht 4 ist letztere mit ihrem Rand gegenüber dem Rand der Keramikschicht 2 zurückversetzt, so daß sich bei dem Substrat 1a ein für die Spannungsfestigkeit maßgeblicher Abstand zwischen den Kupferschichten 3 und 4 ergibt, der etwas größer ist als die Dicke der Keramikschicht 2, und außerdem eine verminderte Neigung zu einer thermomechanisch induzierten Rißbildung erhalten wird. Bei höheren Spannungen ist dieser Abstand aber nicht ausreichend. Zur Erhöhung der Spannungsfestigkeit wird das Substrat 1a in das Substrat 1a' geformt, bei dem anstelle des Überstandes 15 der Überstand 15' gebildet ist und die Kupferschicht 3 im Bereich des Randes 14 S-förmig derart verformt ist, daß der Überstand 15' nicht nur in Richtung der senkrechten Substratebene einen größeren Abstand von der Ebene der Kupferschicht 4 aufweist, sondern am Rand 14 die Kupferschicht 3 auch in einem Randbereich 16 von der Keramikschicht 2 abgelöst ist, hierdurch also der für die Spannungsfestigkeit maßgebliche Abstand zwischen den Kupferschichten 3 und 4 entlang der Keramikschicht 2 wesentlich vergrößert wird.

Zur Umformung des Substrates 1a in das Substrat 1a' mit der höheren Spannungsfestigkeit und reduzierten Neigung zur thermomechanisch induzierten Rißbildung dient das Umformwerkzeug 17, welches insgesamt vier spannbackenartig ausgebildete und jeweils paarweise vorgesehene Werkzeugteile 18 und 19 bzw. 20 und 21 aufweist. Für das Umformen wird das Substrat 1a zwischen Werkzeugteilen 18 und 19 eingespannt, wobei das Werkzeugteil 18 flächig gegen die Kupferschicht 3 und das Werkzeugteil 19 flächig gegen die Kupferschicht 4 anliegen und zumindest das Werkzeugteil 18 mit seinem parallel zum Rand 14 verlaufenden Rand 18' einen gewissen Abstand von dem Rand 14 des Substrates 1a bzw. der Keramikschicht 2 aufweist. Dieser Abstand bestimmt dann die Breite des abgelösten Bereiches 12.

Zwischen den Werkzeugteilen 20 und 21 ist der Überstand 15 flächig eingespannt. Nach dem Einspannen des Substrates 1a im Werkzeug 17 werden die beiden Werkzeugteile 20 und 21 um einen vorgegebenen Hub in der Achsrichtung senkrecht zur Substratebene (Pfeil A) so vorbewegt, daß sich nicht nur die Kupferschicht 3 an ihrem Übergang zum Überstand 15 S-förmig verformt, sondern auch in ihrem vom Werkzeugteil 18 nicht abgestützten Bereich von der Keramikschicht 2 abhebt.

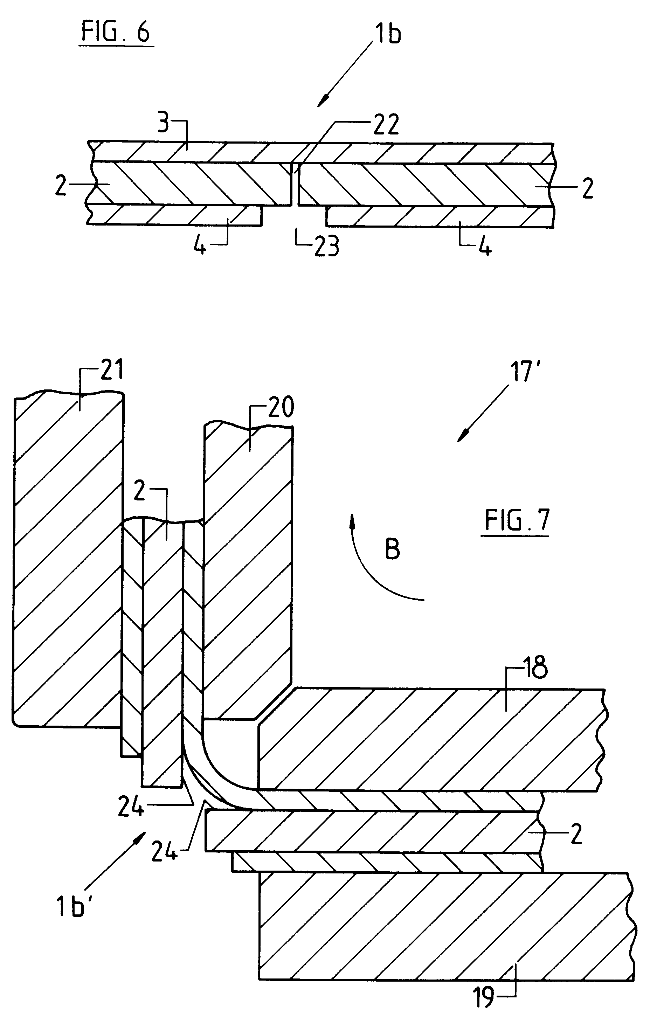

Die Figuren 6 und 7 zeigen ein Substrat 1b sowie ein hieraus durch Umformen gewonnenes Substrat 1b'.

Das Substrat 1b besteht aus einer Keramikschicht 2, die bei 22 durchgehend geschlitzt oder mit einer Sollbruchstelle versehen ist, und zwar beispielsweise durch Laser-Schneiden, durch mechanisches Ritzen oder dergl. Techniken. Bei der Keramikschicht 2 sind wiederum die obere und untere Kupferschicht 3 bzw. 4 vorgesehen, wobei die untere Kupferschicht 4 im Bereich der Schlitzung oder Sollbruchstelle 22 unterbrochen ist.

Durch ein Umformwerkzeug 17', welches dem Werkzeug 17 entspricht und wiederum die Werkzeugteile 18 - 21 aufweist, wird das Substrat 1b in das Substrat 1b' (Fig. 7) umgeformt. Hierfür wird das Substrat mit seinem in den Figuren 6 und 7 rechts von der Sollbruchstelle 22 gebildeten Teil zwischen den Werkzeugteilen 18 und 19 und mit seinem links von der Sollbruchstelle 22 liegenden Teil flächig zwischen den Werkzeugteilen 20 und 21 eingespannt. Die beiden Werkzeugteile 20 und 21 werden dann relativ zu den Werkzeugteilen 18 und 19 geschwenkt, und zwar entsprechend dem Pfeil B der Fig. 7 um eine senkrecht zur Zeichenebene dieser Figur verlaufende und etwa im Bereich der Sollbruchstelle 22 liegende Achse um etwa 90^{o} derart, daß das Substrat 1b zwei relativ zueinander abgewinkelte Abschnitte bildet, die jeweils von einem Schenkel der abgewinkelten und diese Abschnitte zusammenhaltenden Kupferschicht 3, einem Teil der Keramikschicht 2 und einem Teil der Kupferschicht 4 gebildet sind. Die der Keramikschicht 2 abgewandte Seite der Kupferschicht 3 ist dem durch die Abwinklung gebildeten Winkelraum zugewandt.

Beim Abwinkeln wird gleichzeitig die obere Kupferschicht 3 beidseitig der Sollbruchstelle 22 in einem Bereich 24 von der Keramikschicht 2 abgelöst. Die Breite des Bereiches 24 ist wiederum durch den Abstand exakt einstellbar, den die der Sollbruchstelle 22 zugewandten Ränder 18' bzw. 20' der Werkzeugteile 18 und 20 von dieser Sollbruchstelle aufweist.

Die Erfindung wurde voranstehend an Ausführungsbeispielen beschrieben. Es versteht sich, daß Änderungen sowie Abwandlungen innerhalb des Schutzbereichs der Erfindung möglich sind, der durch die Patentansprüche bestimmt wird.

### Bezugszeichenliste

- 1, 1': Substrat
- 1a, 1a': Substrat
- 1b, 1b': Substrat
- 2: Keramikschicht
- 3: Kupferschicht
- 3': Teilbereich
- 3'': Brücke
- 4: Kupferschicht
- 5: Öffnung
- 5': Rand
- 6: Kupferplatte
- 7: Bereich
- 8: Bohrung
- 9: Werkzeug
- 10, 11: Werkzeugteil
- 12: Ausnehmung
- 13: Stempel
- 14: Rand
- 15, 15': Überstand
- 16: Bereich
- 17: Werkzeug
- 18 - 21: Werkzeugteil
- 18', 20': Rand
- 22: Sollbruchstelle
- 23: Unterbrechung
- 24: Bereich

## Patentansprüche

1. Verfahren zum Herstellen eines Keramik-Metall-Substrates, vorzugsweise eines Keramik-Kupfer-Substrates, mit wenigstens einer Keramikschicht (2), die auf beiden Oberflächenseiten mit jeweils wenigstens einer Metallschicht (3, 4) versehen ist, von denen zumindest die eine Metallschicht (3) von einer flächig an der einen Oberflächenseite der Keramikschicht (2) befestigten Metallfolie oder -platine gebildet ist, wobei die Keramikschicht (2) wenigstens eine Kante (5', 14) bildet, über die die eine Metallschicht (3) mit einem Teilbereich übersteht, **dadurch gekennzeichnet**, daß nach dem Aufbringen der wenigstens zwei Metallschichten (3, 4) die eine Metallschicht (3) dieses Ausgangssubstrates (1, 1a, 1b) unter Verwendung eines Werkzeugs (9, 17, 17') bleibend derart mechanisch verformt wird, daß diese eine Metallschicht (3) nach dem Verformen an der Kante (5', 14) von der einen Oberflächenseite der Keramikschicht (2) beabstandet und entlang der Kante (5') über einen Randbereich (7) vorgegebener Breite von der einen Oberflächenseite abgehoben ist.

2. Verfahren nach Anspruch 1, dadurch gekennzeichnet, daß das Ausgangssubstrat (1, 1a, 1b) vor dem Verformen zwischen einem ersten Paar von Werkzeugteilen (10, 11; 18, 19) des Werkzeugs (9, 17, 17') zumindest im Bereich der Kante flächig eingespannt ist, wobei ein Werkzeugteil (10, 18) gegen die der Keramikschicht (2) abgewandte Seite der einen Metallschicht (3) anliegt, und zwar mit einem Abstand von der Kante (5', 14) der Keramikschicht (2), der (Abstand) der Breite des erwähnten Randbereiches (7) entspricht.

3. Verfahren nach Anspruch 1 oder 2, dadurch gekennzeichnet, daß das Werkzeug (9) ein Prägewerkzeug ist, daß das eine Werkzeugteil des Paares matrizenartig mit einer Öffnung oder Ausnehmung (12) versehen ist, und daß das Verformen des Teilbereichs (3') nach dem Einspannen des Ausgangssubstrates (1) durch einen Stempel (13) erfolgt, mit dem der Teilbereich (3') in die Öffnung oder Ausnehmung (12) des einen Werkzeugteils (10) gedrückt wird.

4. Verfahren nach Anspruch 3, dadurch gekennzeichnet, daß das matrizenartige Werkzeugteil zugleich das das Ausgangssubstrat an der wenigstens einen Metallschicht (3) einspannende oder abstützende Werkzeugteil (10) ist.

5. Verfahren nach Anspruch 3 oder 4, gekennzeichnet durch die Herstellung eines Ausgangssubstrates (1), bei dem die Keramikschicht (2) wenigstens eine Unterbrechung, beispielsweise in Form einer Ausnehmung oder einer Öffnung (5) aufweist, die die eine Metallschicht (3) mit wenigstens einem Teilbereich (3') überbrückt, bei dem die andere Metallschicht (4) im Bereich der Unterbrechung (5) ebenfalls unterbrochen ist und bei dem Ränder der Unterbrechung der Keramikschicht (2) die Kanten (5') bilden, wobei der wenigstens eine Teilbereich (3') der einen Metallschicht (3) derart verformt wird, daß aus dem Teilbereich (3') eine an ihrer der Keramikschicht (2) zugewandten Seite konkave Brücke (3'') gebildet ist und die eine Metallschicht (3) an den Kanten (5') in dem Randbereich vorgegebener Breite von der Oberfläche der Keramikschicht (2) abgelöst ist,
wobei vorzugsweise das Verformen des Teilbereichs (3') in die Brücke (3'') unter Verwendung des Prägewerkzeuges erfolgt.

6. Verfahren nach einem der Ansprüche 1 - 5, gekennzeichnet durch die Verwendung eines Biegewerkzeuges mit wenigstens zwei Paaren von Werkzeugteilen (18, 19; 20, 21), von denen die Werkzeugteile eines ersten Paares den Niederhalter (18) und den Gegenhalter (19) bilden und mit den Werkzeugteilen (20, 21) eines zweiten Paares der über die Kante vorstehenden Teilbereich (15) des Ausgangssubstrates (1a, 1b) eingespannt und im Anschluß daran durch Bewegen wenigstens eines Paares (20, 21) relativ zum anderen Paar (18, 19) das Verformen der einen Metallschicht (3) erfolgt,
wobei vorzugsweise das wenigstens eine Paar (20, 21) relativ zu dem anderen Paar (18, 19) in einer Achsrichtung (A) quer zur Ebene der Keramikschicht (2) bewegt und/oder geschwenkt wird.

7. Verfahren nach einem der Ansprüche 1 - 6, dadurch gekennzeichnet, daß die andere Metallschicht (4) mit ihrer der Keramikschicht (2) abgewandten Seite auf einer Trägerschicht, vorzugsweise auf einer Metallplatte (6) befestigt ist, und daß in die Trägerschicht (6) vor dem Verformen des Teilbereichs (3') der einen Metallschicht (3) eine Öffnung oder Bohrung (8) eingebracht wird, durch die dieses Verformen erfolgt.

8. Verfahren nach einem der Ansprüche 1 - 7, gekennzeichnet durch die Herstellung eines Ausgangssubstrats (1b), bei dem an dem Teilbereich der einen Metallschicht (3) zumindest die andere Metallschicht (4) eine Unterbrechung (23) aufweist, wobei die Keramikschicht (2) im Bereich dieser Unterbrechung ebenfalls mit einer Unterbrechung, mit einem Schlitz (22) oder einer Sollbruchstelle versehen wird, und daß anschließend mit dem Biegewerkzeug ein Verformen bzw. Biegen des Ausgangssubstrates derart erfolgt, daß das Substrat (1b') nach dem Biegen eine im Bereich der Unterbrechung, der Schlitzung (22) oder der Sollbruchstelle abgewinkelte Form aufweist mit wenigstens zwei die jeweils eine Metallschicht (3), die Keramikschicht (2) und die andere Metallschicht (4) aufweisenden und einen Winkel miteinander einschließenden Schenkeln.

9. Verfahren nach einem der Ansprüche 1 - 8, dadurch gekennzeichnet, daß Kupferreste auf der Keramikschicht (2) am Randbereich mit einem geeigneten Ätzmittel entfernt werden.

10. Keramik-Metall-Substrat, durch das Verfahren nach einem der Ansprüche 1 - 9.

## Claims

1. Process for manufacturing a ceramic-metal substrate, preferably a ceramic-copper substrate, with at least one ceramic layer (2), which is provided with at least one metal layer (3, 4) on each surface side, of which at least one metal layer (3) takes the form of a metal foil or plate fastened flat to one surface side of the ceramic layer (2), with the ceramic layer (2) forming at least one edge (5 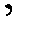 , 14), above which part of the metal layer (3) projects, distinguished by the fact that when at least two metal layers (3, 4) have been deposited, one metal layer (3) of this initial substrate (1, 1a, 1b) is permanently mechanically deformed, using a tool (9, 17, 17 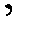 ), in such a way that, following deformation, there is an interval between this one metal layer (3), at the edge (5 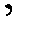 , 14), and one surface side of the ceramic layer (2) and is raised from the one surface side along the edge (5 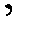 ) over a marginal area (7) with a pre-set width.

2. Process as Claim 1, distinguished by the fact that the initial substrate (1, 1a, 1b) is clamped flat, before deformation, between a first pair of tool parts (10, 11; 18, 19) of the tool (9, 17, 17 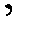 ), at least in the area of the edge, with one tool part (10, 18) fitting closely against the side of one metal layer (3) facing away from the ceramic layer (2), and this at a distance from the edge (5 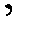 , 14) of the ceramic layer (2), the which (distance) corresponds to the width of the marginal area (7) referred to.

3. Process as Claim 1 or 2, distinguished by the fact that the tool (9) is a stamping tool, that one tool part of the pair is provided with an aperture or recess (12) as in a matrix, and that the deformation of the part (3 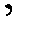 ) following the clamping of the initial substrate (1) is carried out by a stamp (13), with which the part (3 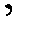 ) is pressed into the aperture or recess (12) of one tool part (10).

4. Process as Claim 3, distinguished by the fact that the matrix-like tool part is simultaneously the tool part (10) clamping or supporting the initial substrate on at least one metal layer (3).

5. Process as Claim 3 or 4, distinguished by the manufacture of an initial substrate (1), in which the ceramic layer (2) has at least one interruption, for example, in the form of a recess or an aperture (5), which bridges the one metal layer (3) with at least one part (3 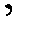 ), and in which the other metal layer (4) is likewise interrupted in the area of the interruption (5), and in which margins of the interruption of the ceramic layer (2) form the edges (5 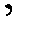 ), with at least one part (3 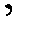 ) of one metal layer (3) being deformed in such a way that a concave bridge (3 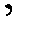 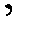 ) is formed from the part (3') on its side facing the ceramic layer (2) and one metal layer (3) is detached from the surface of the ceramic layer (2) at the edges (5 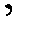 ) in the marginal area with a pre-set width, with the deformation of the part (3 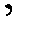 ) into the bridge (3 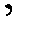 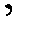 ) being preferably carried out using the stamping tool.

6. Process as one of Claims 1-5, distinguished by the use of a bending tool with at least one pair of tool parts (18, 19; 20, 21), of which the tool parts of a first pair form the holding-down device (18) and the pressure pad (19), and are clamped with the tool parts (20, 21) of a second pair forming the part (15) projecting above the edge of the initial substrate (1a, 1b), and subsequent to this the deformation of one metal layer (3) takes place through the movement of at least one pair (20, 21) relative to the other pair (18, 19), with preferably at least one pair (20, 21) being moved and / or pivoted, relative to the other pair (18, 19) in an axial direction (A) at right angles to the plane of the ceramic layer (2).

7. Process as one of Claims 1-6, distinguished by the fact that the other metal layer (4) is fastened by its side facing away from the ceramic layer (2) to a carrier layer, preferably to a metal plate (6), and that an aperture or bore (8) is created in the carrier layer (6) before the part (3 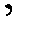 ) of the one metal layer (3) is deformed, through which this deformation takes place.

8. Process as one of Claims 1-7, distinguished by the manufacture of an initial substrate (1b), in which, on part of the one metal layer (3) at least, the other layer (4) has an interruption (23), with the ceramic layer (2) likewise being provided with an interruption, with a slot (22) or with a predetermined breaking point, and by the fact that subsequently the initial substrate is deformed and / or bent, using the bending tool, in such a way that after the bending the substrate (1b 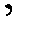 ) has a turned-down form in the area of the interruption, the slot (22) or the predetermined breaking point, with at least two sides, each having a metal layer (3), the ceramic layer (2) and the other metal layer (4) and enclosing an angle between them.

9. Process as one of Claims 1-8, distinguished by the fact that copper residues on the ceramic layer (2) are removed in the marginal area, using a suitable corroding agent.

10. Ceramic-metal substrate obtained through the process as one of Claims 1-9.

## Revendications

1. Procédé de fabrication d'un substrat métal-céramique, si possible d'un substrat cuivre-céramique avec au moins une couche céramique (2) recouverte de chaque côté par au moins une couche de métal superficielle (3,4), cette couche de métal (3) étant constituée d'au moins un feuillet ou une platine métallique fixé(e) horizontalement sur la face superficielle de la couche céramique (2), cette dernière (2) formant au moins un bord (5', 14) au-dessus duquel saille une partie de la couche métallique et caractérisé en ce que, une fois appliquées, les deux couches métalliques (3,4) au moins de ce substrat de sortie (1, 1a, 1b) sont déformées de manière permanente, avec un instrument (9, 17, 17'), de telle sorte que, au bord (5, 14), elles soient décollées de la face superficielle de la couche céramique (2), dans une zone périphérique (7) de largeur prédéterminée.

2. Procédé selon la revendication 1, caractérisé en ce que, avant la déformation, le substrat de sortie (1, 1a, 1b) est, sur le bord au moins, calé horizontalement entre deux premiers couples d'éléments (10, 11; 18,19) de l'outil, et en ce que un de ces couples (10, 18) est en contact direct avec la face de la couche métallique (3) orientée vers la couche céramique (2), à une distance du bord (5', 14) de la couche céramique (2) équivalant à la largeur de la zone périphérique (7) susmentionnée.

3. Procédé selon la revendication 1 ou 2, caractérisé en ce que l'instrument (9) est outil d'estampage, en ce que les éléments du couple susmentionné présentent un orifice ou un évidement (12) pratiqué par estampage, en ce que, une fois le substrat de sortie (1) calé, la couche métallique (3') est déformée par estampage dans l'orifice ou évidement (12) des éléments du couple (10)

4. Procédé selon la revendication 3, caractérisé en ce que l'élément de l'instrument en forme de matrice cale ou appuie le substrat de sortie contre au moins une couche métallique (3).

5. Procédé selon la revendication 3 ou 4, caractérisé par la fabrication d'un substrat de sortie (1) dont la couche céramique (2) présente au moins une interruption sous la forme, par exemple, d'un évidement ou d'un orifice (5) surplombé par une partie (3') de la couche métallique (3), caractérisé en ce que l'autre couche métallique (4) est également interrompue au niveau de l'interruption, en ce que l'interruption est délimitée en partie par des bords (5') de la couche céramique (2), en ce que une partie au moins d'une des couches métalliques (3) est déformée et forme un pont concave (3'') sur la face de la couche métallique orientée vers la couche céramique (2), en ce que la couche métallique (3) est décollée de la surface de la couche céramique (2) à hauteur des bords, sur une largeur correspondant à celles des zones périphériques, et en ce que une partie (3') de la couhce métallique est déformée en un pont (3'') grâce, si possible, à l'outil d'estampage.

6. Procédé selon l'une ou l'autre des revendications 1 à 5, caractérisé par l'utilisation d'un outil de flexion composé d'au moins deux paires d'éléments (18, 19; 20, 21). La première paire est constituée d'un serre-flan (18) et d'un serre-pièce (19), tandis que les éléments (20, 21) de la seconde paire calent la partie (15) du substrat de sortie (1a, 1b) saillante par rapport au bord. Ce procédé est également caractérisé en ce que une des couches métalliques (3) est ensuite déformée en déplaçant et / ou en basculant au moins une paire (20, 21) par rapport à l'autre (18, 19), suivant un axe transversal (A) par rapport à la couche céramique (2).

7. Procédé selon l'une ou l'autre des revendications 1 à 6 caractérisé en ce que la face de l'autre couche métallique (4) orientée vers la couche céramique (2) est fixée sur un substrat, si possible une plaque métallique (6), en ce que un orifice ou un alésage (8) est pratiqué dans ce substrat (6) avant la déformation de la partie d'une des couches métalliques (3), et en ce que la déformation se fait par le biais de cet orifice ou alésage (8).

8. Procédé selon l'une ou l'autre des revendications 1 à 7, caractérisé par la fabrication d'un substrat de sortie (1b) dont l'une des couches métalliques (4) au moins présente une interruption (23) à hauteur de la la partie de l'autre couche métallique (3), en ce que la couche céramique (2) est elle aussi interrompue par une entaille (22) ou une section de rupture intentionnellement prévue, à hauteur de l'interruption de la couche métallique (4), en ce que le substrat (1b') de sortie est ensuite déformé ou plié à l'aide de l'instrument de flexion, pour donner lieu à une forme angulaire dans la zone de l'interruption, de l'entaille (22) ou de la section de rupture intentionnellement prévue. Cette forme est constitué de de deux côtés délimités chacun par une couche métallique (3) , la couche céramique (2) et l'autre couche métallique (4).

9. Procédé selon l'une ou l'autre des revendications 1 à 8, caractérisé en ce que les résidus de cuivre sur la couche céramique (2) sont supprimés en périphérie à l'aide d'un agent de gravure approprié.

10. Substrat métal - céramique fabriqué par un procédé selon l'une ou l'autre des revendications 1 à 9.
